# EUROPÄISCHE PATENTSCHRIFT

(11) **EP 3 851 859 B1**
(45) Veröffentlichungstag und Bekanntmachung des Hinweises auf die Patenterteilung: **07.05.2025**
(21) Anmeldenummer: 20207713.7
(22) Anmeldetag: 16.11.2020
(51) Int. Cl.: G01R 1/20, H01C 3/08, H01C 17/00

(54) **WIDERSTANDSANORDNUNG, MESSSCHALTUNG MIT EINER WIDERSTANDSANORDNUNG SOWIE VERFAHREN ZUR HERSTALLUNG EINES BANDFÖRMIGEN WERKSTOFFVERBUNDES FÜR EINE WIDERSTANDSANORDNUNG**
RESISTOR ARRANGEMENT, MEASURING CIRCUIT WITH A RESISTOR ARRANGEMENT AND METHOD FOR MANUFACTURING A STRIP-SHAPED MATERIAL COMPOSITE FOR A RESISTOR ARRANGEMENT
DISPOSITIF DE RÉSISTANCE, CIRCUIT DE MESURE DOTÉ D'UN DISPOSITIF DE RÉSISTANCE AINSI QUE PROCÉDÉ DE FABRICATION D'UNE MATIÈRE COMPOSITE EN FORME DE BANDE POUR UN DISPOSITIF DE RÉSISTANCE

(30) Priorität: 17.01.2020 DE 102020101070
(43) Veröffentlichungstag der Anmeldung: 21.07.2021
(73) Patentinhaber: Wieland & Munich Electrification GmbH, 81373 München (DE)
(72) Erfinder: Wolf, Michael, 89077 Ulm (DE); Thumm, Gerhard, 89155 Erbach (DE); Voggeser, Volker, 89250 Senden (DE); Goede, Stefan, 80799 München (DE); Reichmeyer, Konstantin, 85567 Grafing (DE)
(74) Vertreter: Hentrich Patent- & Rechtsanwaltspartnerschaft mbB

(56) Entgegenhaltungen:
- DE-A1- 102014 103 343
- DE-B3- 102014 015 805
- DE-T2- 69 409 614
- DE-T2- 69 409 614
- KR-A- 20180 003 505

## Beschreibung

Die Erfindung betrifft eine Widerstandsanordnung, insbesondere umfassend: ein erstes elektrisch leitendes Anschlusselement und ein zweites elektrisch leitendes Anschlusselement, ein erstes Widerstandselement, das mit dem ersten Anschlusselement elektrisch leitend verbunden ist, ein zweites Widerstandselement, das mit dem zweiten Anschlusselement elektrisch leitend verbunden ist, ein elektrisch leitendes Zwischenelement, das zwischen dem ersten und dem zweiten Widerstandselement angeordnet ist und mit diesen Widerstandelementen elektrisch leitend verbunden ist, wobei die Anschlusselemente, die Widerstandelemente und das Zwischenelement nebeneinander in einer Reihe angeordnet sind. Die Anschlusselemente und das Zwischenelement einerseits und die Widerstandselemente andererseits bestehen aus unterschiedlichen Materialien, wobei sich das Material des ersten Widerstandselements vom Material des zweiten Widerstandselements unterscheidet. Die Erfindung betrifft weiterhin eine Messchaltung mit der Widerstandsanordnung sowie ein Verfahren zur Herstellung eines bandförmigen Werkstoffverbundes für die Widerstandsanordnung.

Für die Strommessung in elektronischen Schaltungen werden Messwiderstände verwendet, die in Reihe zu dem zu überwachenden Bauteil geschaltet sind, wobei aus der über den als Shunt-Widerstand oder kurz als Shunt bezeichneten Messwiderstand abfallenden Spannung der Strom bestimmt werden kann. Die korrekte und verlässliche Strommessung ist besonders wichtig z.B. in einem Batteriemanagementsystem eines Hybrid- oder Elektrofahrzeugs oder für die Überwachung einer Brennstoffzellenvorrichtung.

Ein solcher niederohmiger Messwiderstand als Shunt mit ca. 10 - 50 µOhm kann aus einem längsnahtgeschweißten Verbundmaterialband hergestellt werden. Dies ist beispielsweise aus der EP 0 605 800 A1 bekannt. Das Verbundmaterial wird aus drei Materialbändern hergestellt, indem die einzelnen Metallbänder jeweils über eine Längsnaht miteinander durch ein Elektronenstrahl- oder Laserschweißverfahren verbunden werden.

Die Anforderungen an die korrekte und verlässliche Strommessung in den heutigen Hybrid- und Elektrofahrzeugen, in denen zum Teil sehr hohe Dauerströme gefahren werden, steigen zunehmend. Dabei ist die Überwachung der sicherheitsrelevanten Bauteile bei solchen Strömen von großer Bedeutung. Die Li-Ionen-Batterien mit ihrer hohen Energiedichte müssen in diesem Zusammenhang sehr genau überwacht werden, um sicherzustellen, dass sie sich immer in einem sicheren Betriebszustand befinden. Die Strommessung in der Batterie ist demnach zwingend notwendig, um bestimmte Betriebsparameter wie den Ladezustand (SOC / State of Charge) oder den Betriebszustand (SOH / State of health) oder die einwandfreie Funktion (SOF/State of functions) zu überwachen. Bei einem Sicherheitslevel in diesem Einsatzgebiet von bis zu ASIL C und D (ISO 26262) ist es notwendig, die relevanten Messinstrumente über eine redundante Funktion abzusichern, damit die Sicherheitslevel überhaupt realisiert werden können.

Die Redundanz der Strommessung, die zur Erreichung des Sicherheitslevels ASIL C notwendig ist, kann durch die Kombination verschiedener Sensoren, also die gleichzeitige Erfassung zweier komplett unterschiedlicher Messsignale erreicht werden, zum Beispiel durch eine Spannungsmessung an einem Shunt-Widerstand bekannter Größe und durch die Messung der Hall-Spannung am stromdurchflossenen Leiter in einem Magnetfeld. Dieser Aufbau ist mit relativ hohen Kosten verbunden, auch weil die Integration gering ist und viele Bauteile mit einem entsprechend hohen Bauraumbedarf benötigt werden.

Die Redundanz in der Messwerterfassung lässt sich auch erreichen, indem anstelle der Hall-Spannungsmessung ein zweiter Shunt-Widerstand in Reihe zum ersten Shunt-Widerstand geschaltet und an den beiden Shunt-Widerständen des so gebildeten Doppelshunts jeweils eine unabhängige Spannungsmessung zur Ermittlung der Stromstärke durchgeführt wird. Durch Vergleich der beiden Messungen kann dann ermittelt werden, ob die Messungen plausibel sind oder ein Fehler vorliegt. Der Doppelshunt ermöglicht somit die Diagnose von "Single Point Faults", nämlich von Drift, Widerstandsänderung, De-Kontaktierung einzelner Messabgriffe. Ferner bietet er bessere Diagnosemöglichkeiten für die Shuntelektronik durch Plausibilitätsprüfung der Messung durch zwei Shunt-Elemente integriert in einem Bauteil. Die Strommessung mittels Doppelshunt ist hinsichtlich ihres Aufbaus einfacher und kostengünstiger als eine Strommessung mittels Einfachshunt und Hall-Effekt. Die Möglichkeit der Fertigung eines Mehrfachshunts ist aus der US 9,343,208 B2 bekannt.

Allerdings besteht bei einem derartigen Doppelshunt die Möglichkeit, dass beide Messungen dem gleichen Fehler unterliegen, beispielsweise durch eine parallele Drift der beiden Widerstände.

Die DE 694 09 614 T2 und die KR 10 2018 0 003 505 A offenbaren einen Präzisionswiderstand gemäß dem Oberbegriff des Anspruchs 1 mit drei Anschlüssen und zwei Widerständen aus unterschiedlichem Material, wobei die Anschlüsse und die Widerstände in Reihe geschaltet sind. Nachteilig ist hier der hohe Materialaufwand und der komplexe Aufbau der Widerstände.

Die DE 10 2014 103 343 A1 beschreibt eine Mehrfach-Stromsensorvorrichtung mit zwei Widerstandsteilen, die über ein gemeinsames Verbindungsteil miteinander elektrisch verbunden sind. Die Widerstandsteile und das Verbindungsteil sind nicht nebeneinander in einer Reihe angeordnet, zudem sind die Widerstandsteile und das Verbindungsteil nicht jeweils aus unterschiedlichen Materialien gefertigt. Weiterhin wird auch ein Verfahren zur Herstellung eines bandförmigen Werkstoffverbunds, wobei drei Bänder aus einem Material mit hoher elektrischer Leitfähigkeit und zwei Bänder aus einem Widerstandsmaterial bereitgestellt und miteinander zu einem Verbund von Bändern längsverschweißt werden.

Die DE 10 2014 015 805 B3 betrifft ein Verbundsmaterialband zur Herstellung eines elektrischen Widerstands, wobei ein Übergang von einem Aluminium-Bauteil zu einem Kupfer-Bauteil ermöglicht ist, wobei die Verbindung zwischen dem Aluminium-Bauteil einerseits und einem kupferhaltigen Bauteil andererseits durch ein besonderes Fügeverfahren ermöglicht ist.

Der Erfindung liegt daher die Aufgabe zugrunde, eine Widerstandanordnung und eine Messschaltung, sowie ein Verfahren zur Herstellung eines bandförmigen Werkstoffverbunds bereit zu stellen, die eine Reduzierung des einzusetzenden Materials und eine Kostenreduktion ermöglichen.

Diese Aufgabe wird durch eine Widerstandsanordnung mit den Merkmalen des Anspruchs 1, durch eine Messschaltung mit den Merkmalen des Anspruchs 8 und durch ein Verfahren mit den Merkmalen des Anspruchs 11 gelöst. Vorteilhafte Ausgestaltungen mit zweckmäßigen Weiterbildungen der Erfindung sind in den abhängigen Ansprüchen angegeben.

Die Widerstandsmessanordnung der eingangs geschilderten Art zeichnet sich dadurch aus, dass die beiden Widerstandselemente gezielt aus unterschiedlichen Materialien, insbesondere aus unterschiedlichen Werkstoffen, die insbesondere eine unterschiedliche chemische Zusammensetzungen aufweisen können, gefertigt werden, wobei insbesondere als Beispiele für Widerstandslegierungen CuMn10Ni4 und CuMn12Ni2 und CuMn14Ni2 und CuZn15Mn15Al genannt werden können. Die Widerstandsmessanordnung umfasst dann Materialpaarungen aus diesen Legierungen, also zum Beispiel CuMn10Ni4 für das erste Widerstandselement und CuMn14Ni2 für das zweite Widerstandselement.

Damit wird insbesondere sicher gestellt, dass die beiden Widerstandselemente aus unterschiedlichen Produktions-Chargen stammen. Unerkannte Fehler in einer Charge, die beispielsweise zu einer Drift führen könnten, können somit nicht gleichzeitig und in gleicher Weise in beiden Widerstandselementen auftreten. Damit ist der Vorteil einer Verbesserung der Redundanz der Messung verbunden. Zudem zeichnet sich die Widerstandsanordnung dadurch aus, dass nur das erste Anschlusselement und das zweite Anschlusselement Verbindungsmittel zur Einbindung in einen Stromkreis aufweisen, während das Zwischenelement nicht an einen Stromkreis anschließbar ist.

Vorgesehen ist weiterhin, dass die beiden Anschlusselemente plattenförmig und das Zwischenelement streifenförmig gebildet sind, und dass das Zwischenelement schmaler als jedes der beiden Anschlusselemente ist. Dadurch ist eine Material- und Platzersparnis ermöglicht, da das Zwischenelement nur die Funktion hat, Anschlüsse für die Spannungsmessung, nicht jedoch Einrichtungen für den Anschluss an einen Stromkreis aufzunehmen. Ebenso können auch die Widerstandelemente streifenförmig gebildet sein.

Die Dicke der Widerstandselemente ist jeweils geringer als sowohl die Dicke der Anschlusselemente als auch die Dicke des Zwischenelements, was Vorteile bei der Montage zum Beispiel auf einem PCB (printed circuit board) bietet und auch ein Löten ermöglicht.

Dabei ist die Gestaltung so gewählt, dass das erste Widerstandselement eine Dicke aufweist, die sich von der Dicke des zweiten Widerstandselements unterscheidet. Dies ermöglicht eine bessere Anpassung der Widerstandswerte der beiden Widerstandselemente.

Bevorzugt ist weiterhin, wenn ein erstes Messanschlusspaar zur Messung der über dem ersten Widerstandselement abfallenden elektrischen Spannung und ein zweites Messanschlusspaar zur Messung der über dem zweiten Widerstandselement abfallenden Spannung vorgesehen sind und wenn aus dem ersten Messanschlusspaar ein erster Messanschluss und aus dem zweiten Messanschlusspaar ein zweiter Messanschluss dem Zwischenelement zugeordnet ist.

Alternativ oder auch ergänzend besteht die Möglichkeit, dass ein Messanschlusspaar zur Messung der über dem ersten Widerstandselement abfallenden elektrischen Spannung und ein drittes Messanschlusspaar zur Messung der über dem ersten Widerstandselement und dem zweiten Widerstandselement kumuliert abfallenden Spannung vorgesehen sind.

Wenn der Widerstandswert des ersten Widerstandselements kleiner als der Widerstandswert des zweiten Widerstandselements ist, insbesondere sich so deutlich unterscheidet, dass die beiden Spannungen mit unterschiedlichen Messbereichen gemessen werden müssen, ist die Unabhängigkeit der Messwerte verbessert.

Diese Widerstandsanordnung kann insbesondere in eine Messschaltung integriert sein. Die Messschaltung umfasst dann eine derartige, vorstehend geschilderte Widerstandsanordnung sowie einen ersten Spannungsabgriff zur Messung einer ersten elektrischen Spannung, die über dem ersten Widerstandselement abfällt, einen zweiten Spannungsabgriff zur Messung einer zweiten elektrischen Spannung, die mindestens die über dem zweiten Widerstandselement abfallende elektrische Spannung umfasst, und zumindest ein elektronisches Bauteil zum Ermitteln der ersten elektrischen Spannung und der zweiten elektrischen Spannung.

Mittels eines Komparators zum Vergleich der gemessenen ersten elektrischen Spannung und der gemessenen zweiten elektrischen Spannung kann die Verlässlichkeit der Messwerte beurteilt werden kann.

Vorzugsweise ist das elektronische Bauteil so eingerichtet, dass die Messung der ersten elektrischen Spannung und die Messung der zweiten elektrischen Spannung unabhängig voneinander erfolgen können, so dass ein Ausfall einer der beiden Messketten durch den Vergleich der beiden Messungen erkannt werden kann.

Ein Verfahren zur Herstellung eines bandförmigen Werkstoffverbunds, umfasst die folgenden Schritte:
a. Bereitstellen mindestens eines ersten Bandes, eines zweiten Bandes und eines dritten Bandes aus einem Material mit hoher elektrischer Leitfähigkeit,
b. Bereitstellen mindestens eines vierten Bandes und eines fünften Bandes aus jeweils einem Widerstandsmaterial, wobei sich das Material des vierten Bandes und das Material des fünften Bandes unterscheiden,
c. Längsnahtschweißen der Bänder, so dass ein Verbund von Bändern gebildet wird, bei dem die beiden Bänder aus Widerstandsmaterial jeweils an ihren beiden Längskanten an eines der Bänder aus dem Material mit hoher elektrischer Leitfähigkeit grenzen.

Dabei besteht die Möglichkeit, dass im Schritt c) zunächst ein erster Teilverbund, der aus dem ersten und dem vierten Band besteht, und ein zweiter Teilverbund, der aus dem zweiten und dritten Band sowie dem zwischen diesen beiden Bändern angeordneten fünften Band besteht, jeweils durch Längsnahtschweißen gebildet werden und danach der erste Teilverbund und der zweite Teilverbund durch Längsnahtschweißen verbunden werden.

Vorgesehen ist weiterhin, dass zwischen dem Verfahrensschritt b) und dem Verfahrensschritt c) die Bänder derart angeordnet werden, dass sich das vierte und das fünfte Band jeweils zwischen zwei Bändern aus einem Material mit hoher elektrischer Leitfähigkeit befinden, und dass sich eines der Bänder aus Material mit hoher elektrischer Leitfähigkeit zwischen den beiden Bändern aus Widerstandsmaterial befindet. Mit diesem vorstehend genannten Verfahren und seinen Varianten bezüglich des Schrittes c) und der Realisierung der Anordnung der Bänder zwischen den Verfahrensschritten b) und c) wird ein bandförmiger Verbundwerkstoff bereit gestellt, bei dem durch den Schritt des Zertrennens des bandförmigen Werkstoffverbunds quer zur Bandlängsrichtung eine Widerstandsanordnung der vorstehend erläuterten hergestellt und bereit gestellt wird.

Dabei besteht auch die Möglichkeit, dass in die beiden Anschlusselemente die Verbindungsmittel zum Anschluss der Widerstandsanordnung an einen Stromkreis eingebracht werden.

Weiterhin kann auch ein Trimmen mindestens eines der Widerstandselemente erfolgen, mit dem der gewünschte Widerstandswert eingestellt wird. Das Trimmen erfolgt durch ein Kürzen des einen Widerstandselements, so dass sich dessen Leitungsquerschnittsfläche verringert.Die vorstehend in der Beschreibung genannten Merkmale und Merkmalskombinationen sowie die nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen oder in Alleinstellung verwendbar, ohne den Rahmen der Erfindung zu verlassen. Es sind somit auch Ausführungen als von der Erfindung umfasst und offenbart anzusehen, die in den Figuren nicht explizit gezeigt oder erläutert sind, jedoch durch separierte Merkmalskombinationen aus den erläuterten Ausführungen hervorgehen und erzeugbar sind.

Weitere Vorteile, Merkmale und Einzelheiten der Erfindung ergeben sich aus den Ansprüchen, der nachfolgenden Beschreibung bevorzugter Ausführungsformen sowie anhand der Zeichnungen. Dabei zeigen:
- Fig. 1: eine perspektivische, schematische Darstellung einer Widerstandsanordnung,
- Fig. 2: eine der Figur 1 entsprechende Darstellung mit dem verbundenen ersten und dem zweiten Messanschlusspaar, und
- Fig. 3: eine der Figur 1 entsprechende Darstellung mit dem verbundenen ersten und dem dritten Messanschlusspaar.

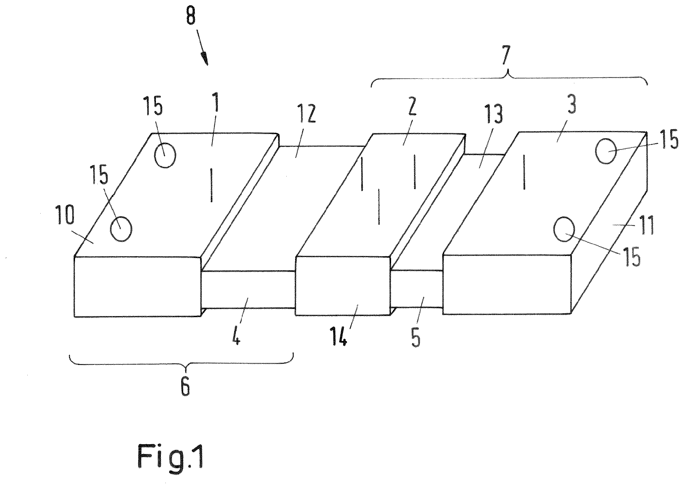

In Figur 1 ist eine Widerstandsanordnung gezeigt, die vorteilhaft bereit gestellt wird durch ein Verfahren zur Herstellung eines bandförmigen Werkstoffverbunds, wobei das Verfahren die folgenden Schritte umfasst:
a) Bereitstellen mindestens eines ersten Bandes 1, eines zweiten Bandes 2 und eines dritten Bandes 3 aus einem Material mit hoher elektrischer Leitfähigkeit,
b) Bereitstellen mindestens eines vierten Bandes 4 und eines fünften Bandes 5 aus jeweils einem Widerstandsmaterial, wobei sich das Material des vierten Bandes 4und das Material des fünften Bandes 5 unterscheiden,
c) Längsnahtschweißen der Bänder 1, 2, 3, 4, 5, so dass ein Verbund von Bändern 1, 2, 3, 4, 5 gebildet wird, bei dem die beiden Bänder aus Widerstandsmaterial jeweils an ihren beiden Längskanten an eines der Bänder 1, 2, 3 aus dem Material mit hoher elektrischer Leitfähigkeit grenzen.

Dabei besteht die Möglichkeit, dass im Schritt c) zunächst ein erster Teilverbund 6, der aus dem ersten Band 1 und dem vierten Band 4 besteht, und ein zweiter Teilverbund 7, der aus dem zweiten Band 2 und dritten Band 3 sowie dem zwischen diesen beiden Bändern 2, 3 angeordneten fünften Band 5 besteht, jeweils durch Längsnahtschweißen gebildet werden und danach der erste Teilverbund 6 und der zweite Teilverbund 7 durch Längsnahtschweißen verbunden werden.

Alternativ kann das Verfahren auch so modifiziert werden, dass zwischen dem Verfahrensschritt b) und dem Verfahrensschritt c) die Bänder derart angeordnet werden, dass sich das vierte Band 4 und das fünfte Band 5 jeweils zwischen zwei Bändern aus einem Material mit hoher elektrischer Leitfähigkeit befinden, und dass sich eines der Bänder 2 aus Material mit hoher elektrischer Leitfähigkeit zwischen den beiden Bändern 4, 5 aus Widerstandsmaterial befindet.

Wenn dann das Zertrennen des bandförmigen Werkstoffverbunds quer zur Bandlängsrichtung erfolgt, ist eine Widerstandsanordnung 8 hergestellt, die sich durch den folgenden Aufbau auszeichnet: ein erstes elektrisch leitendes Anschlusselement 10 und ein zweites elektrisch leitendes Anschlusselement 11, ein erstes Widerstandselement 12, das mit dem ersten Anschlusselement 10 elektrisch leitend verbunden ist, ein zweites Widerstandselement 13, das mit dem zweiten Anschlusselement 11 elektrisch leitend verbunden ist, ein elektrisch leitendes Zwischenelement 14, das zwischen dem ersten Widerstandselement 12 und dem zweiten Widerstandselement 13 angeordnet ist und mit diesen Widerstandelementen 12, 13 elektrisch leitend verbunden ist, wobei die Anschlusselemente 10, 11, die Widerstandelemente 12, 13 und das Zwischenelement 14 nebeneinander in einer Reihe angeordnet sind, und wobei die Anschlusselemente 10, 11 und das Zwischenelement 14 einerseits und die Widerstandselemente 12, 13 andererseits aus unterschiedlichen Materialien bestehen. Wesentlich dabei ist, dass sich das Material des ersten Widerstandselements 12 vom Material des zweiten Widerstandselements 13 unterscheidet, so dass eine "Parallel-Drift" der beiden Widerstandselemente 12, 13 oder ähnliche Effekte sicherer ausgeschlossen werden können, als wenn beide Widerstandselemente 12, 13 aus dem gleichen Material oder sogar aus der gleichen Material-Charge sind.

Das Zwischenelement 14 ist dabei streifenförmig gebildet und schmaler als jedes der beiden plattenförmigen Anschlusselemente 10, 11.

Die Figur 1 lässt erkennen, dass nur das erste Anschlusselement 10 und das zweite Anschlusselement 11 Verbindungsmittel 15 zur Einbindung in einen Stromkreis aufweisen, also das Zwischenelement 14 nicht an einen Stromkreis anschließbar ist.

Die Dicke der Widerstandselemente 12, 13 ist jeweils geringer als sowohl die Dicke der Anschlusselemente 10, 11 als auch die Dicke des Zwischenelements 14. Dies ermöglicht insbesondere, dass die Widerstandselement 12, 13 einen Abstand zu einer Platine aufweisen, wenn die Widerstandsanordnung 8 auf dieser Platine befestigt wird. Auch ist ein Trimmen mindestens eines der Widerstandselemente 12, 13 leichter möglich bei der Herstellung der Widerstandsanordnung 8.

Außerdem weist das erste Widerstandselement 12 eine Dicke auf, die sich von der Dicke des zweiten Widerstandselements 13 unterscheidet, so dass eine bessere Anpassung der Widerstandswerte der beiden Widerstandselemente 12, 13 ermöglicht ist, insbesondere im Hinblick darauf, dass der Widerstandswert des ersten Widerstandselements 12 kleiner, insbesondere deutlich kleiner als der Widerstandswert des zweiten Widerstandselements 13 ist, um so unterschiedliche Messbereichen zu erzwingen und die Unabhängigkeit der Messwerte zu verbessern

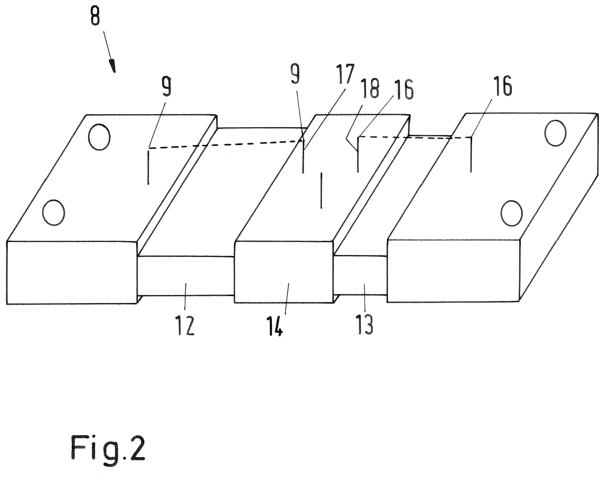

Figur 2 zeigt, dass ein erstes Messanschlusspaar 9 zur Messung der über dem ersten Widerstandselement 12 abfallenden elektrischen Spannung und ein zweites Messanschlusspaar 16 zur Messung der über dem zweiten Widerstandselement 13 abfallenden Spannung vorgesehen sind, wobei aus dem ersten Messanschlusspaar 9 ein erster Messanschluss und aus dem zweiten Messanschlusspaar ein zweiter Messanschluss dem Zwischenelement 14 zugeordnet ist.

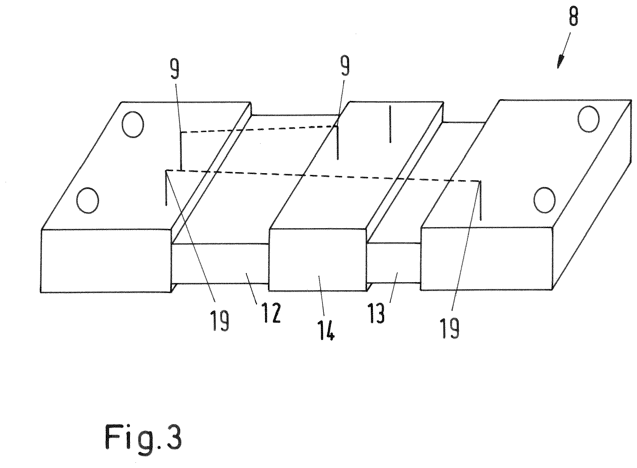

Es besteht dabei allerdings auch die Möglichkeit, dass das erste Messanschlusspaar 9 zur Messung der über dem ersten Widerstandselement 12 abfallenden elektrischen Spannung und ein weiteres Messanschlusspaar 19 zur Messung der über dem ersten Widerstandselement 12 und dem zweiten Widerstandselement 13 kumuliert abfallenden Spannung vorgesehen sind, wie dies in Figur 3 dargestellt ist.

Diese Messanordnung kann in einer Messschaltung integriert werden, die neben der Widerstandsanordnung 8 umfasst einen ersten Spannungsabgriff zur Messung einer ersten elektrischen Spannung, die über dem ersten Widerstandselement 12 abfällt, einen zweiten Spannungsabgriff zur Messung einer zweiten elektrischen Spannung, die mindestens die über dem zweiten Widerstandselement 13 abfallende elektrische Spannung umfasst, und zumindest ein elektronisches Bauteil zum Ermitteln der ersten elektrischen Spannung und der zweiten elektrischen Spannung, wobei ein Komparator zum Vergleich der gemessenen ersten elektrischen Spannung und der gemessenen zweiten elektrischen Spannung vorgesehen ist, mit dem die Verlässlichkeit der Messwerte beurteilt werden kann.

Das elektronische Bauteil ist dabei so eingerichtet, dass die Messung der ersten elektrischen Spannung und die Messung der zweiten elektrischen Spannung unabhängig voneinander erfolgen können

### BEZUGSZEICHENLISTE:

- 1: erstes Band
- 2: zweites Band
- 3: drittes Band
- 4: viertes Band
- 5: fünftes Band
- 6: erster Teilverbund
- 7: zweiter Teilverband
- 8: Widerstandsanordnung
- 9: erstes Messanschlusspaar
- 10: erstes Anschlusselement
- 11: zweites Anschlusselement
- 12: erstes Widerstandselement
- 13: zweites Widerstandselement
- 14: Zwischenelement
- 15: Verbindungsmittel
- 16: zweites Messanschlusspaar
- 17: erster Messanschluss
- 18: zweiter Messanschluss
- 19: weiteres Messanschlusspaar

## Patentansprüche

1. Widerstandsanordnung (8) umfassend:
ein erstes elektrisch leitendes Anschlusselement (10) und ein zweites elektrisch leitendes Anschlusselement (11),
ein erstes Widerstandselement (12), das mit dem ersten Anschlusselement (10) elektrisch leitend verbunden ist,
ein zweites Widerstandselement (13), das mit dem zweiten Anschlusselement (11) elektrisch leitend verbunden ist,
ein elektrisch leitendes Zwischenelement (14), das zwischen dem ersten Widerstandselement (12) und dem zweiten Widerstandselement (13) angeordnet ist und mit diesen Widerstandelementen (12, 13) elektrisch leitend verbunden ist,
wobei die Anschlusselemente (10, 11), die Widerstandelemente (12), (13) und das Zwischenelement (14) nebeneinander in einer Reihe angeordnet sind,
und wobei die Anschlusselemente (10, 11) und das Zwischenelement (14) einerseits und die Widerstandselemente (12, 13) andererseits aus unterschiedlichen Materialien bestehen,
wobei sich das Material des ersten Widerstandselements (12) vom Material des zweiten Widerstandselements (13) unterscheidet, **dadurch gekennzeichnet, dass** nur das erste Anschlusselement (10) und das zweite Anschlusselement (11) Verbindungsmittel (15) zur Einbindung in einen Stromkreis aufweisen.

2. Widerstandsanordnung (8) nach Anspruch 1, **dadurch gekennzeichnet, dass** die beiden Anschlusselemente (10, 11) plattenförmig und das Zwischenelement (14) streifenförmig gebildet sind und dass das Zwischenelement (14) schmaler als jedes der beiden Anschlusselemente (10, 11) ist.

3. Widerstandsanordnung (8) nach einem der Ansprüche 1 oder 2, **dadurch gekennzeichnet, dass** die Dicke der Widerstandselemente (12, 13) jeweils geringer ist als sowohl die Dicke der Anschlusselemente (10, 11) als auch die Dicke des Zwischenelements (14).

4. Widerstandsanordnung (8) nach einem der Ansprüche 1 bis 3, **dadurch gekennzeichnet, dass** das erste Widerstandselement (12) eine Dicke aufweist, die sich von der Dicke des zweiten Widerstandselements (13) unterscheidet.

5. Widerstandsanordnung (8) nach einem der Ansprüche 1 bis 4, **dadurch gekennzeichnet, dass** ein erstes Messanschlusspaar (9) zur Messung der über dem ersten Widerstandselement (12) abfallenden elektrischen Spannung und ein zweites Messanschlusspaar (16) zur Messung der über dem zweiten Widerstandselement (13) abfallenden Spannung vorgesehen sind und dass aus dem ersten Messanschlusspaar (9) ein erster Messanschluss (17) und aus dem zweiten Messanschlusspaar (16) ein zweiter Messanschluss (18) dem Zwischenelement (14) zugeordnet ist.

6. Widerstandsanordnung (8) nach einem der Ansprüche 1 bis 4, **dadurch gekennzeichnet, dass** ein erstes Messanschlusspaar (9) zur Messung der über dem ersten Widerstandselement (12) abfallenden elektrischen Spannung und ein weiteres Messanschlusspaar (19) zur Messung der über dem ersten Widerstandselement (12) und dem zweiten Widerstandselement (13) kumuliert abfallenden Spannung vorgesehen sind.

7. Widerstandsanordnung (8) nach Anspruch 6, **dadurch gekennzeichnet, dass** der Widerstandswert eines der Widerstandselemente (12, 13 ) kleiner als der Widerstandswert des anderen Widerstandselements (13, 12) ist.

8. Messschaltung umfassend eine Widerstandsanordnung (8) nach einem der Ansprüche 1 bis 7, einen ersten Spannungsabgriff zur Messung einer ersten elektrischen Spannung, die über dem ersten Widerstandselement (12) abfällt, einen zweiten Spannungsabgriff zur Messung einer zweiten elektrischen Spannung, die mindestens die über dem zweiten Widerstandselement (13) abfallende elektrische Spannung umfasst, und zumindest ein elektronisches Bauteil zum Ermitteln der ersten elektrischen Spannung und der zweiten elektrischen Spannung.

9. Messschaltung nach Anspruch 8, **dadurch gekennzeichnet,**
**dass** ein Komparator zum Vergleich der gemessenen ersten elektrischen Spannung und der gemessenen zweiten elektrischen Spannung vorgesehen ist.

10. Messschaltung nach Anspruch 8 oder 9, **dadurch gekennzeichnet, dass** das elektronische Bauteil so eingerichtet ist, dass die Messung der ersten elektrischen Spannung und die Messung der zweiten elektrischen Spannung unabhängig voneinander erfolgen können.

11. Verfahren zur Herstellung eines bandförmigen Werkstoffverbunds, wobei das Verfahren die folgenden Schritte umfasst:
a. Bereitstellen mindestens eines ersten Bandes (1) , eines zweiten Bandes (2) und eines dritten Bandes (3) jeweils aus einem Material mit hoher elektrischer Leitfähigkeit,
b. Bereitstellen mindestens eines vierten Bandes (4) und eines fünften Bandes (5) aus jeweils einem Widerstandsmaterial, wobei sich das Material des vierten Bandes (4) und das Material des fünften Bandes (5) unterscheiden,
c. Längsnahtschweißen der Bänder (1, 2, 3, 4, 5), so dass ein Verbund von Bändern (1, 2, 3, 4, 5) gebildet wird, bei dem die beiden Bänder (4, 5) aus Widerstandsmaterial jeweils an ihren beiden Längskanten an eines der Bänder (1, 2, 3) aus dem Material mit hoher elektrischer Leitfähigkeit grenzen.

12. Verfahren nach Anspruch 11, **dadurch gekennzeichnet, dass** im Schritt c) zunächst ein erster Teilverbund (6) , der aus dem ersten Band (1) und dem vierten Band (4) besteht, und ein zweiter Teilverbund (7), der aus dem zweiten Band (2) und dritten Band (3) sowie dem zwischen diesen beiden Bändern (2, 3) angeordneten fünften Band (5) besteht, jeweils durch Längsnahtschweißen gebildet werden und danach der erste Teilverbund (6) und der zweite Teilverbund (7) durch Längsnahtschweißen verbunden werden.

13. Verfahren nach Anspruch 11, **dadurch gekennzeichnet, dass** zwischen dem Verfahrensschritt b) und dem Verfahrensschritt c) die Bänder derart angeordnet werden, dass sich das vierte Band (4) und das fünfte Band (5) jeweils zwischen zwei Bändern aus einem Material mit hoher elektrischer Leitfähigkeit befinden, und dass sich eines der Bänder (2) aus Material mit hoher elektrischer Leitfähigkeit zwischen den beiden Bändern aus Widerstandsmaterial (4,5) befindet.

14. Verfahren nach einem der Ansprüche 11 bis 13, umfassend den Schritt des Zertrennens des bandförmigen Werkstoffverbunds quer zur Bandlängsrichtung, zur Herstellung einer Widerstandsanordnung (8) nach einem der Ansprüche 1 bis 8.

15. Verfahren nach Anspruch 14, **dadurch gekennzeichnet, dass** in die beiden Anschlusselemente (10,11) Verbindungsmittel (15) zum Anschluss der Widerstandsanordnung (8) an einen Stromkreis eingebracht werden.

16. Verfahren nach Anspruch 14 oder 15, **dadurch gekennzeichnet, dass** ein Trimmen mindestens eines der Widerstandselemente (12, 13) erfolgt.

## Claims

1. Resistor arrangement (8) comprising:
a first electrically conductive connection element (10) and a second electrically conductive connection element (11),
a first resistance element (12) which is electrically conductively connected to the first connection element (10),
a second resistance element (13), which is electrically conductively connected to the second connection element (11),
an electrically conductive intermediate element (14), which is arranged between the first resistance element (12) and the second resistance element (13) and is electrically conductively connected to these resistance elements (12, 13),
wherein the connection elements (10, 11), the resistor elements (12), (13) and the intermediate element (14) are arranged next to one another in a row,
and wherein the connection elements (10, 11) and the intermediate element (14) on the one hand and the resistance elements (12, 13) on the other hand consist of different materials,
wherein the material of the first resistance element (12) differs from the material of the second resistance element (13), **characterized in that** only the first connection element (10) and the second connection element (11) have connecting means (15) for integration into a circuit.

2. Resistor arrangement (8) according to claim 1, **characterized in that** the two connection elements (10, 11) are plate-shaped and the intermediate element (14) is strip-shaped, and **in that** the intermediate element (14) is narrower than each of the two connection elements (10, 11).

3. Resistor arrangement (8) according to one of claims 1 or 2, **characterized in that** the thickness of the resistance elements (12, 13) is in each case less than both the thickness of the connection elements (10, 11) and the thickness of the intermediate element (14).

4. Resistor arrangement (8) according to any one of claims 1 to 3, **characterized in that** the first resistance element (12) has a thickness that is different from the thickness of the second resistance element (13).

5. Resistor arrangement (8) according to one of claims 1 to 4, **characterized in that** a first measuring connection pair (9) for measuring the electrical voltage dropped across the first resistance element (12) and a second measuring connection pair (16) for measuring the voltage dropped across the second resistance element (13) are provided, and **in that** a first measuring connection (17) from the first measuring connection pair (9) and a second measuring connection (18) from the second measuring connection pair (16) are assigned to the intermediate element (14).

6. Resistor arrangement (8) according to one of claims 1 to 4, **characterized in that** a first measuring connection pair (9) is provided for measuring the electrical voltage dropping across the first resistance element (12) and a further measuring connection pair (19) is provided for measuring the voltage dropping cumulatively across the first resistance element (12) and the second resistance element (13).

7. Resistor arrangement (8) according to claim 6, **characterized in that** the resistance value of one of the resistance elements (12, 13 ) is smaller than the resistance value of the other resistance element (13, 12).

8. Measuring circuit comprising a resistor arrangement (8) according to any one of claims 1 to 7, a first voltage tap for measuring a first electrical voltage dropped across the first resistance element (12), a second voltage tap for measuring a second electrical voltage comprising at least the electrical voltage dropped across the second resistance element (13), and at least one electronic component for determining the first electrical voltage and the second electrical voltage.

9. Measuring circuit according to claim 8, **characterized in that** a comparator is provided for comparing the measured first electrical voltage and the measured second electrical voltage

10. Measuring circuit according to claim 8 or 9, **characterized in that** the electronic component is set up in such a way that the measurement of the first electrical voltage and the measurement of the second electrical voltage can be carried out independently of one another.

11. Method of manufacturing a strip-shaped composite material, wherin the method comprises the following steps:
a. Providing at least a first strip (1), a second strip (2) and a third strip (3) each made of a material with high electrical conductivity,
b. Providing at least a fourth band (4) and a fifth band (5) each made of a resistor material, the material of the fourth band (4) and the material of the fifth band (5) being different,
c. Longitudinal seam welding of the strips (1, 2, 3, 4, 5), so that a composite of strips (1, 2, 3, 4, 5) is formed, in which the two strips (4, 5) of resistance material each adjoin one of the strips (1, 2, 3) of the material with high electrical conductivity at their two longitudinal edges.

12. Method according to claim 11, **characterized in that** in step c) first a first partial composite (6), which consists of the first strip (1) and the fourth strip (4), and a second partial composite (7), which consists of the second strip (2) and third strip (3) and the fifth strip (5) arranged between these two strips (2, 3), are each formed by longitudinal seam welding and then the first partial composite (6) and the second partial composite (7) are joined by longitudinal seam welding.

13. Method according to claim 11, **characterized in that** between method step b) and method step c) the tapes are arranged in such a way that the fourth tape (4) and the fifth tape (5) are each located between two tapes made of a material with high electrical conductivity, and **in that** one of the tapes (2) made of material with high electrical conductivity is located between the two tapes made of resistive material (4, 5).

14. Method according to any one of claims 11 to 13, comprising the step of severing the strip-shaped material composite transversely to the longitudinal direction of the strip, for producing a resistor arrangement (8) according to any one of claims 1 to 8.

15. Method according to claim 14, **characterized in that** the connecting means (15) for connecting the resistor arrangement (8) to a circuit are introduced into the two connection elements (10, 11).

16. Method according to claim 14 or 15, **characterized in that** a trimming of at least one of the resistance elements (12, 13) is carried out.

## Revendications

1. Agencement de résistance (8) comprenant :
un premier élément de raccordement électroconducteur (10) et un deuxième élément de raccordement électroconducteur (11),
un premier élément de résistance (12) qui est connecté de manière électroconductrice au premier élément de raccordement (10),
un deuxième élément de résistance (13), qui est connecté de manière électroconductrice au deuxième élément de raccordement (11),
un élément intermédiaire électroconducteur (14) qui est disposé entre le premier élément de résistance (12) et le deuxième élément de résistance (13) et est connecté de manière électroconductrice à ces éléments de résistance (12, 13),
dans lequel les éléments de raccordement (10, 11), les éléments de résistance (12), (13) et l'élément intermédiaire (14) sont disposés côte à côte en une série,
et dans lequel les éléments de raccordement (10, 11) et l'élément intermédiaire (14) d'une part et les éléments de résistance (12, 13) d'autre part sont constitués de différents matériaux,
dans lequel le matériau du premier élément de résistance (12) est différent du matériau du deuxième élément de résistance (13), **caractérisé en ce que** seuls le premier élément de raccordement (10) et le deuxième élément de raccordement (11) présentent des moyens de liaison (15) pour intégration dans un circuit électrique.

2. Agencement de résistance (8) selon la revendication 1, **caractérisé en ce que** les deux éléments de raccordement (10, 11) sont formés en forme de plaque et l'élément intermédiaire (14) en forme de bande et **en ce que** l'élément intermédiaire (14) est plus étroit que chacun des deux éléments de raccordement (10, 11).

3. Agencement de résistance (8) selon l'une quelconque des revendications 1 ou 2, **caractérisé en ce que** l'épaisseur des éléments de résistance (12, 13) est respectivement inférieure à aussi bien l'épaisseur des éléments de raccordement (10, 11) que de l'épaisseur de l'élément intermédiaire (14).

4. Agencement de résistance (8) selon l'une quelconque des revendications 1 à 3, **caractérisé en ce que** le premier élément de résistance (12) présente une épaisseur qui diffère de l'épaisseur du deuxième élément de résistance (13).

5. Agencement de résistance (8) selon l'une quelconque des revendications 1 à 4, **caractérisé en ce qu'**une première paire de raccords de mesure (9) pour mesurer la tension électrique baissant via le premier élément de résistance (12) et une deuxième paire de raccords de mesure (16) pour mesurer la tension baissant via le deuxième élément de résistance (13) sont prévues, et **en ce qu'**un premier raccord de mesure (17) de la première paire de raccords de mesure (9) et un deuxième raccord de mesure (18) de la deuxième paire de raccords de mesure (16) sont attribués à l'élément intermédiaire (14).

6. Agencement de résistance (8) selon l'une quelconque des revendications 1 à 4, **caractérisé en ce qu'**une première paire de raccords de mesure (9) pour mesurer la tension électrique baissant via le premier élément de résistance (12) et une paire de raccords de mesure supplémentaire (19) pour mesurer la tension baissant de manière cumulée via le premier élément de résistance (12) et le deuxième élément de résistance (13) sont prévues.

7. Agencement de résistance (8) selon la revendication 6, **caractérisé en ce que** la valeur de résistance d'un des éléments de résistance (12, 13) est inférieure à la valeur de résistance de l'autre élément de résistance (13, 12).

8. Circuit de mesure comprenant un agencement de résistance (8) selon l'une quelconque des revendications 1 à 7, une première prise de tension pour mesurer une première tension électrique qui baisse via le premier élément de résistance (12), une deuxième prise de tension pour mesurer une deuxième tension électrique qui comprend au moins la tension électrique qui baisse via le deuxième élément de résistance (13), et au moins un composant électronique pour déterminer la première tension électrique et la deuxième tension électrique.

9. Circuit de mesure selon la revendication 8, **caractérisé en ce que**
un comparateur pour comparer la première tension électrique mesurée et la deuxième tension électrique mesurée est prévu.

10. Circuit de mesure selon la revendication 8 ou 9, **caractérisé en ce que** le composant électronique est configuré de sorte que la mesure de la première tension électrique et la mesure de la deuxième tension électrique peuvent être effectuées indépendamment l'une de l'autre.

11. Procédé de fabrication d'un matériau composite en forme de bande, dans lequel le procédé comprend les étapes suivantes :
a) préparation d'au moins une première bande (1), d'une deuxième bande (2) et d'une troisième bande (3) respectivement en un matériau à haute conductivité électrique,
b) mise à disposition d'au moins une quatrième bande (4) et d'une cinquième bande (5) respectivement en un matériau de résistance, dans lequel le matériau de la quatrième bande (4) et le matériau de la cinquième bande (5) diffèrent,
c) soudage longitudinal des bandes (1, 2, 3, 4, 5), de sorte qu'un assemblage de bandes (1, 2, 3, 4, 5) est formé, dans lequel les deux bandes (4, 5) en matériau de résistance sont respectivement contiguës par leurs deux bords longitudinaux à l'une des bandes (1, 2, 3) en matériau à haute conductivité électrique.

12. Procédé selon la revendication 11, **caractérisé en ce qu'**à l'étape c), un premier sous-ensemble (6), constitué de la première bande (1) et de la quatrième bande (4), et un deuxième sous-ensemble (7), constitué de la deuxième bande (2) et de la troisième bande (3) ainsi que de la cinquième bande (5) disposée entre ces deux bandes (2, 3), sont d'abord formés respectivement par soudage longitudinal, puis le premier sous-ensemble (6) et le deuxième sous-ensemble (7) sont liés par soudage longitudinal.

13. Procédé selon la revendication 11, **caractérisé en ce qu'**entre l'étape b) et l'étape c) du procédé, les bandes sont disposées de sorte que la quatrième bande (4) et la cinquième bande (5) se trouvent respectivement entre deux bandes d'un matériau à haute conductivité électrique, et **en ce qu'**une des bandes (2) en matériau à haute conductivité électrique se trouve entre les deux bandes en matériau de résistance (4, 5).

14. Procédé selon l'une quelconque des revendications 11 à 13, comprenant l'étape de coupe du matériau composite en forme de bande transversalement à la direction longitudinale de bande pour fabriquer un agencement de résistance (8) selon l'une quelconque des revendications 1 à 8.

15. Procédé selon la revendication 14, **caractérisé en ce que** des moyens de liaison (15) sont introduits dans les deux éléments de raccordement (10, 11) pour raccorder l'agencement de résistance (8) à un circuit électrique.

16. Procédé selon la revendication 14 ou 15, **caractérisé en ce qu'**un ajustage d'au moins un des éléments de résistance (12, 13) est effectué.
